(19) Europäisches Patentamt
European Patent Office
Office européen des brevets

(11) **EP 4 280 141 A1**

(12) **EUROPÄISCHE PATENTANMELDUNG**

(43) Veröffentlichungstag:
**22.11.2023   Patentblatt 2023/47**

(21) Anmeldenummer: **23169530.5**

(22) Anmeldetag: **24.04.2023**

(51) Internationale Patentklassifikation (IPC):
**G06Q 10/20** (2023.01)      **G07C 5/08** (2006.01)
**G01R 31/00** (2006.01)

(52) Gemeinsame Patentklassifikation (CPC):
**G06Q 10/20; G01R 31/006; G07C 5/0808**

(84) Benannte Vertragsstaaten:
**AL AT BE BG CH CY CZ DE DK EE ES FI FR GB
GR HR HU IE IS IT LI LT LU LV MC ME MK MT NL
NO PL PT RO RS SE SI SK SM TR**
Benannte Erstreckungsstaaten:
**BA**
Benannte Validierungsstaaten:
**KH MA MD TN**

(30) Priorität: **18.05.2022   DE 102022204945**

(71) Anmelder: **Robert Bosch GmbH
70442 Stuttgart (DE)**

(72) Erfinder:
• **Wendel, Viktor
  97688 Bad Kissingen (DE)**
• **Friese, Andreas
  72285 Pfalzgrafenweiler (DE)**

(54)   **VERFAHREN ZUR DIAGNOSE EINES FAHRRADS**

(57)   Die Erfindung betrifft ein Verfahren zur Diagnose eines Fahrrads, insbesondere eines Elektrofahrrads, mittels eines Entscheidungsbaums umfassend folgende Schritte:
- Bereitstellung einer Fehlerinformation oder einer Symptominformation;
- Ermittlung eines Diagnoseverfahrensschritts für das Fahrrad basierend auf der Fehlerinformation oder der Symptominformation;
- Ansteuerung des Fahrrads basierend auf dem ermittelten Diagnoseverfahrensschritt;
- Erfassen eines Diagnosesignals basierend auf dem angesteuerten Fahrrads;
- Ermittlung eines weiteren Diagnoseverfahrensschritts, eines Fehlers oder eines ein Symptom begründenden Fehlers basierend auf dem erfassten Diagnosesignal.

**Fig. 1**

**Beschreibung**

Offenbarung der Erfindung

Die Erfindung betrifft ein Verfahren zur Diagnose eines Fahrrads, insbesondere eines Elektrofahrrads, mittels eines Entscheidungsbaums umfassend folgende Schritte:

- Bereitstellung einer Fehlerinformation oder einer Symptominformation;

- Ermittlung eines Diagnoseverfahrensschritts für das Fahrrad basierend auf der Fehlerinformation oder der Symptominformation;

- Ansteuerung des Fahrrads basierend auf dem ermittelten Diagnoseverfahrensschritt;

- Erfassen eines Diagnosesignals basierend auf dem angesteuerten Fahrrad;

- Ermittlung eines weiteren Diagnoseverfahrensschritts, eines Fehlers oder eines ein Symptom begründenden Fehlers basierend auf dem erfassten Diagnosesignal.

Vorteilhaft kann durch das erfindungsgemäße Verfahren die Diagnose des Fahrrads optimiert werden.

Unter einem Entscheidungsbaum soll im Zusammenhang dieser Anmeldung insbesondere ein mehrstufiger Entscheidungsprozess mit mehreren Entscheidungsoptionen verstanden werden. Der Entscheidungsbaum dient dabei der Darstellung der Entscheidungsregeln, wobei die Entscheidungen hierarchisch gemäß einer Reihenfolge erfolgen. Der Entscheidungsbaum beziehungsweise die mit dem Entscheidungsbaum verknüpfte Reihenfolge der Entscheidung kann dabei statisch oder dynamisch ausgebildet sein. Unter einem statischen Entscheidungsbaum soll dabei verstanden werden, dass die Entscheidungsprozesse und die Reihenfolge der Entscheidungsprozesse nicht mehr geändert werden. Unter einem dynamischen Entscheidungsbaum soll dabei verstanden werden, dass die Entscheidungsprozesse und/oder die Reihenfolge der Entscheidungsprozesse anpassbar sind, beispielsweise über ein Update der Software. Das Verfahren ist vorzugsweise als ein computerimplementiertes Verfahren ausgebildet, wobei zumindest ein Verfahrensschritt oder alle Verfahrensschritte von einem Computer durchgeführt werden. Vorzugsweise erfolgen die Entscheidungsprozesse, vorzugsweise alle Entscheidungsprozesse, auf dem Elektrofahrrad oder einer externen Vorrichtung, wie beispielsweise einem Smartphone. Die externe Vorrichtung ist dabei zur drahtlosen Kommunikation mit dem Elektrofahrrad, beispielsweise mittels BLE (Bluetooth Low Energy) oder Mobilfunk, ausgebildet.

Unter einem Elektrofahrrad soll im Zusammenhang dieser Anmeldung insbesondere ein Fahrrad verstanden, dass eine Antriebseinheit zur Unterstützung des Fahrers aufweist. Das Elektrofahrrad ist vorzugsweise als ein E-Bike, ein Pedelec, ein Lastenfahrrad, ein Klappfahrrad oder dergleichen ausgebildet. Die Antriebseinheit weist einen Motor auf, der beispielsweise als ein Mittelmotor oder als ein Nabenmotor ausgebildet sein kann. Der Motor ist vorzugsweise als ein Elektromotor ausgebildet. Die Antriebseinheit ist mit einem Energiespeicher zur Versorgung der Antriebseinheit mit Energie verbunden. Die Energieversorgungseinheit ist vorzugsweise als ein Akkupack ausgebildet und weist ein Akkugehäuse auf, das bevorzugt lösbar mit einem Rahmen des Fahrrads verbunden ist. Das Elektrofahrrad umfasst eine Elektronik mit einer Steuereinheit zur Steuerung oder Regelung des Elektrofahrrads. Die Elektronik umfasst vorzugsweise eine Sensoreinheit, wobei die Sensoreinheit beispielsweise Bewegungssensoren, Drehmomentsensoren, Geschwindigkeitssensoren, einen GNSS Empfänger, Magnetsensoren oder dergleichen aufweisen kann. Zudem umfasst die Elektronik eine Kommunikationsschnittstelle zur drahtlosen Verbindung des Elektrofahrrads mit einer externen Vorrichtung, wie beispielsweise einem Smartphone, und/oder einem Server. Zudem kann das Elektrofahrrad weitere Zusatzkomponenten oder Peripheriegeräte umfassen oder verbindbar mit diesen ausgebildet sein, wie beispielsweise einen Boardcomputer, eine insbesondere elektronische Gangschaltung, eine Lichteinheit zur Beleuchtung der Straße und/oder als Rückleuchte, ein Antiblockiersystem, ein Schloss und/oder eine weitere Komponente.

Unter einer Fehlerinformation soll im Zusammenhang dieser Anmeldung insbesondere ein Fehlercode, eine Fehleranzeige, ein Fehlerbild oder dergleichen verstanden werden, die durch eine Komponente erfasst und dem Verfahren zur Diagnose bereitstellbar sind. Beispielsweise ist denkbar, dass der Akkupack des Elektrofahrrads eine zu hohe Temperatur des Akkupacks erfasst und diese Information als Fehlerinformation der Elektronik des Fahrrads oder einem Server bereitstellt. Die Fehlerinformation wird vorzugsweise durch das Elektrofahrrad oder durch eine externe Vorrichtung erfasst und/oder bereitgestellt.

Im Gegensatz hierzu soll unter einer Symptominformation im Zusammenhang dieser Anmeldung insbesondere eine Information bezüglich eines Fehlers verstanden werden, der nicht durch eine Fehlerinformation erfassbar ist. Die Symptominformation ist dabei beispielsweise durch eine symptombasierte Analyse eines Menschen erfassbar, der das vorliegende Fehlverhalten prüft und einschätzt. Die Symptominformation wird vorzugsweise durch eine Nutzereingabe erfasst und/oder bereitgestellt. Die Nutzereingabe kann durch das Elektrofahrrad, beispielsweise einem Boardcomputer, oder mittels einer externen Vorrichtung erfolgen.

Das Diagnosesignal kann von dem Elektrofahrrad, einer externen Vorrichtung, wie beispielsweise einem Smartphone, oder einem Benutzer erfasst werden.

Des Weiteren ist denkbar, dass die Fehlerinformation oder die Symptominformation durch einen Server bereitgestellt wird.

Weiterhin wird vorgeschlagen, dass die Ansteuerung des Fahrrads eine mechanische oder elektrische Komponente betrifft. Bei der mechanischen Komponente kann es sich beispielhaft um die Antriebseinheit, die elektronische Gangschaltung, das Antiblockiersystem, etc. handeln. Bei der elektrischen Komponente kann es sich beispielsweise um eine Lichteinheit handeln. Vorteilhaft kann durch die Ansteuerung ein Funktionstest durchgeführt werden.

Zudem wird vorgeschlagen, dass die Ansteuerung des Fahrrads eine Kommunikationsschnittstelle des Fahrrads betrifft. Die Kommunikationsschnittstelle kann zur kurzreichweiten Kommunikation, beispielsweise BLE, und/oder zur langreichweitigen Kommunikation, beispielsweise Mobilfunk, ausgebildet sein. Vorteilhaft kann durch die Ansteuerung ein Funktionstest durchgeführt werden. Die Ansteuerung kann beispielsweise als ein Prüfsignal erfolgen.

Des Weiteren wird vorgeschlagen, dass die Ansteuerung des Fahrrads und das Erfassen des Diagnosesignals automatisch, insbesondere durch das Fahrrad, erfolgt. Vorteilhaft kann dadurch eine robuste Diagnose gewährleistet werden. Es ist ebenso denkbar, dass dieser Schritt semi-automatisch abläuft und eine Nutzereingabe, beispielsweise zum Starten oder zur Auswertung des Ergebnisses.

Weiterhin wird vorgeschlagen, dass das Diagnosesignal mittels einer Benutzereingabe erfasst wird. Vorteilhaft kann dadurch die Diagnose verbessert werden.

Zudem wird vorgeschlagen, dass das Verfahren vollständig oder teilweise automatisch erfolgt, wobei das teilweise automatische Verfahren lediglich die Symptominformation als Benutzereingabe benötigt. Vorteilhaft kann dadurch ein einfaches und effizientes Diagnoseverfahren bereitgestellt werden.

Des Weiteren wird vorgeschlagen, dass basierend auf dem weiteren Diagnoseverfahrensschritt eine Benutzereingabeaufforderung erfolgt. Die Benutzereingabeaufforderung kann als eine Abfrage ausgebildet sein, die den nächsten Diagnoseverfahrensschritt zur Auswahl stellt. Alternativ ist auch denkbar, dass beispielsweise die Benutzereingabeaufforderung den Benutzer auffordert, eine Handlung am Fahrrad vorzunehmen, beispielsweise einen Schalter, Knopf, etc. zur Steuerung einer Funktion zu betätigen, eine Komponente oder Kabel aus- und/oder einzustecken oder dergleichen.

Weiterhin wird vorgeschlagen, dass dem Diagnoseverfahrensschritt, insbesondere jedem Diagnoseverfahrensschritt, eine Kostenkenngröße und/oder eine Nutzenkenngröße zugeordnet ist. Vorteilhaft kann dadurch ein effizientes Diagnoseverfahren bereitgestellt werden. Die Kostenkenngröße entspricht dabei insbesondere einer Größe oder einer Abschätzung, die den Aufwand, die Dauer und/oder die Kosten des Diagnoseverfahrensschritts entspricht. Die Nutzenkenngröße entspricht dabei insbesondere einem Beitrag des zugeordneten Diagnoseverfahrensschritt zur Ermittlung des Fehlers oder des das Symptom begründenden Fehlers.

Zudem wird vorgeschlagen, dass eine Reihenfolge der Verfahrensschritte basierend auf historischer Felddaten geändert wird. Die Änderung erfolgt dabei über ein computerimplementiertes Verfahren. Vorteilhaft kann dadurch das Verfahren optimiert werden.

Des Weiteren wird vorgeschlagen, dass der Fehlerbaum, insbesondere eine Reihenfolge der ermittelten Diagnoseverfahrensschritte, mittels einer Rückkoppelungsschleife optimiert wird. Vorteilhaft kann dadurch das Verfahren weiter optimiert werden.

Weiterhin wird vorgeschlagen, dass der Fehlerbaum, insbesondere die Reihenfolge der ermittelten Diagnoseverfahrensschritte, mittels eines maschinellen Lernsystems angepasst wird. Unter einem maschinellen Lernsystem sollen im Zusammenhang dieser Anmeldung insbesondere Algorithmen verstanden werden, die mittels Trainingsdaten ein statistisches Modell aufbauen. Über das statistische Modell sind beispielsweise Parameter und Attribute ermittelbar, die über den Umfang der Trainingsdaten hinausgehen. Bei den Algorithmen des maschinellen Lernsystems kann es sich dabei um Algorithmen für ein überwachtes Lernen, ein unüberwachtes Lernen oder ein bestärkendes Lernen handeln. Das maschinelle Lernsystem kann beispielsweise als ein neuronales Netzwerk ausgebildet sein. Das Trainieren des maschinellen Lernsystems erfolgt vorzugsweise auf einem Server. Zusätzlich ist denkbar, dass das Training des maschinellen Lernsystems auch lokal auf dem Fahrrad oder der externen Vorrichtung erfolgt und im Anschluss durch den Server die Vielzahl von trainierten maschinellen Lernsystemen zusammengeführt werden.

Zudem wir vorgeschlagen, dass die Kostenkenngröße und/oder die Nutzenkenngröße basierend auf der Rückkopplungsschleife oder des maschinellen Lernsystems angepasst wird. Vorteilhaft kann dadurch das Verfahren optimiert werden.

Alternativ betrifft die Erfindung ein Verfahren zur Diagnose eines Fahrrads, insbesondere eines Elektrofahrrads, umfassend folgende Schritte:

- Starten eines Diagnoseverfahrensschritts;

- Erfassen einer optischen und/oder einer akustischen Signalkenngröße;

- Signalverarbeitung der optischen und/oder akustischen Signalkenngröße;

- Ermittlung eines weiteren Diagnoseverfahrensschritts, eines Fehlers oder eines Symptoms basierend auf der optischen und/oder akustischen Signalkenngröße.

Vorteilhaft kann durch das Verfahren eine größere Anzahl an Diagnosen bereitgestellt werden.

Das Elektrofahrrad und/oder die externe Vorrichtung weist zumindest ein optisches Sensorelement auf, das zu Erfassung der optischen Signalkenngröße ausgebildet ist. Das optische Sensorelement kann beispielsweise als eine Kamera ausgebildet sein. Das Elektrofahrrad und/oder die externe Vorrichtung weist zumindest ein akustisches Sensorelement auf, das zu Erfassung der akustischen Signalkenngröße ausgebildet ist. Das akustische Sensorelement kann beispielsweise als ein Mikrophon ausgebildet sein. Die externe Vorrichtung kann dabei als ein Smartphone, als ein Tablet oder auch als eine speziell zur Diagnose vorgesehenen Diagnosevorrichtung ausgebildet sein.

Des Weiteren wird vorgeschlagen, dass die Signalverarbeitung mittels einer Mustererkennung oder einer Frequenzanalyse erfolgt. Vorteilhaft können mittels der Signalverarbeitung Artefakte aus den erfassten Signalkenngrößen ermittelt. Diese Artefakte können im Anschluss einem Fehler- oder einem Symptombild zugeordnet werden.

Weiterhin wird vorgeschlagen, dass ein maschinelles Lernsystem, insbesondere ein Deep Learning Algorithmus oder ein neuronales Netzwerk, zur Ermittlung des weiteren Diagnoseverfahrensschritts, des Fehlers oder des Symptoms eingesetzt wird. Insbesondere erfolgt die Ermittlung der Artefakte und/oder die Zuordnung der Artefakte zu einem Fehler- oder Symptombild mittels des maschinellen Lernsystems.

Zudem wird vorgeschlagen, dass der Diagnoseverfahrensschritt mittels einer Benutzereingabe gestartet wird. Alternativ ist auch denkbar, dass der Diagnoseverfahrensschritt automatisch, insbesondere durch das Fahrrad, gestartet wird. Ebenso ist denkbar, dass der Diagnoseverfahrensschritt mittels eines drahtgebundenen Signals einer Diagnosevorrichtung gestartet wird. Zudem ist denkbar, dass der Diagnoseverfahrensschritt mittels eines drahtlosen Signals einer Diagnosevorrichtung, eines Servers oder einer Cloud gestartet wird.

Zeichnungen

Weitere Vorteile ergeben sich aus der folgenden Zeichnungsbeschreibung. Die Zeichnungen, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:

Fig. 1 ein System zur Diagnose eines Fahrrads in einer schematischen Ansicht;

Fig. 2 ein Flussdiagramm mit einem beispielhaften Verfahren zur Diagnose des Fahrrads mittels eines Entscheidungsbaums;

Fig. 3 ein Flussdiagram mit einem beispielhaften Verfahren zu Generierung des Entscheidungsbaums;

Fig. 4 ein Flussdiagramm mit einem weiteren beispielhaften Verfahren zur Diagnose des Fahrrads mittels eines Entscheidungsbaums.

Beschreibung der Ausführungsbeispiele

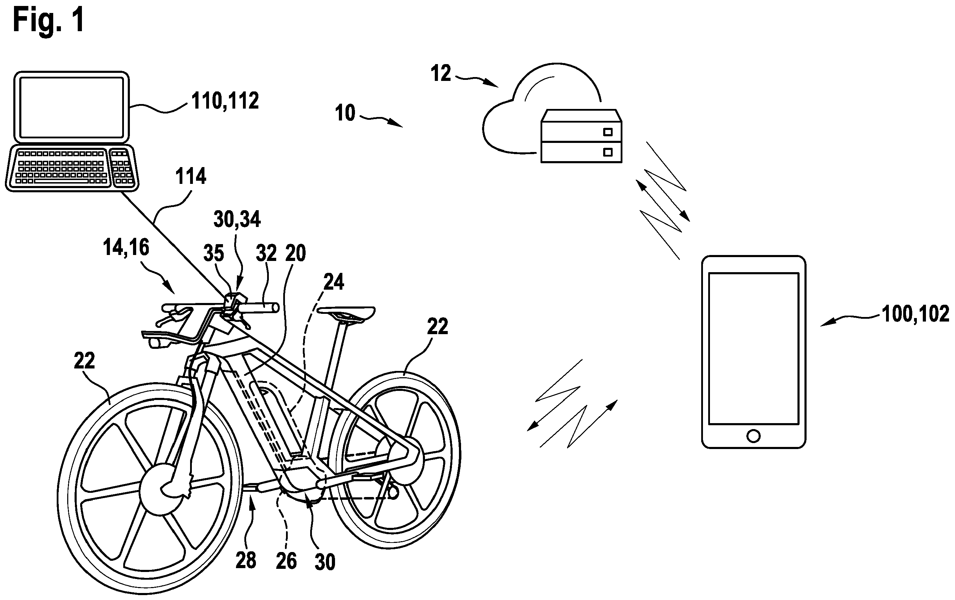

In Fig. 1 ist ein System 10 zur Diagnose eines Fahrrads in einer schematischen Ansicht gezeigt.

Das System 10 umfasst einen Server 12, beispielhaft in Form eines Web-Servers, und ein Fahrrad 14. Das Fahrrad 14 ist beispielhaft als ein Elektrofahrrad 16 ausgebildet. Das Elektrofahrrad 16 kann beispielsweise als ein Pedelec oder als ein E-Bike ausgebildet sein.

Das Elektrofahrrad 16 weist ein Gehäuse in Form eines Rahmens 20 bzw. eines Fahrradrahmens auf. Mit dem Rahmen 20 sind zwei Räder 22 verbunden. Zudem weist das Elektrofahrrad 16 einen Energiespeicher 24 in Form eines Akkupacks auf. Zudem weist das Elektrofahrrad 16 eine Antriebseinheit 26 auf, die einen Elektromotor beziehungsweise einen Hilfsmotor umfasst. Der Elektromotor ist vorzugsweise als ein Permanentmagnet-erregter, bürstenloser Gleichstrommotor ausgebildet. Der Elektromotor ist beispielhaft als ein Mittelmotor ausgebildet, wobei auch ein Nabenmotor oder dergleichen denkbar ist. Das Elektrofahrrad 16, insbesondere die Antriebseinheit 26 des Elektrofahrrads 16, wird über den Energiespeicher 24 mit Energie versorgt. Der Energiespeicher 24 kann von außen am Rahmen 20 befestigbar oder im Rahmen 20 integriert ausgebildet sein.

Die Antriebseinheit 26 umfasst eine Steuereinheit (nicht dargestellt), die zur Steuerung oder Regelung des Elektrofahrrads 16, insbesondere des Elektromotors, ausgebildet ist. Das Elektrofahrrad 16 weist eine Tretkurbel 28 auf. Die Tretkurbel 28 weist eine Tretkurbelwelle (nicht dargestellt) auf. Die Steuereinheit des Elektrofahrrads 16 ist mit einer Sensoreinheit (nicht dargestellt) verbunden. Die Sensoreinheit des Elektrofahrrads 16 umfasst beispielhaft mehrere Sensorelemente, wie einen Drehmomentsensor, einen Bewegungssensor, beispielsweise in Form eines Beschleunigungssensors, und einen Magnetsensor.

Die Steuereinheit und die Antriebseinheit 26 mit dem Elektromotor und der Tretkurbelwelle sind in einem mit dem Rahmen 20 verbundenen Antriebsgehäuse angeordnet. Die Antriebsbewegung des Elektromotors wird vorzugsweise über ein Getriebe (nicht dargestellt) auf die Tretkurbelwelle übertragen, wobei die Größe der Unterstützung durch die Antriebseinheit 26 mittels der Steuereinheit gesteuert oder geregelt wird. Die Steuereinheit ist dazu ausgebildet die Antriebseinheit 26 derart anzusteuern, dass der Fahrer des Elektrofahrrads 16 beim Pedalieren unterstützt wird. Vorzugsweise ist die Steuereinheit durch den Fahrer bedienbar ausgebildet, sodass der Fahrer den Unterstützungsgrad einstellen kann.

Die Steuereinheit und die Sensoreinheit sind einer Elektronik (nicht dargestellt) des Elektrofahrrads 16 zugeordnet. Die Elektronik umfasst beispielhaft eine Leiterplatte, auf der eine Recheneinheit in Form einer CPU, eine Speichereinheit und die Sensoreinheit angeordnet ist. Die Elektronik ist beispielhaft vollständig in dem Antriebsgehäuse der Antriebseinheit 26 angeordnet. Es ist allerdings auch denkbar, dass die Elektronik nur teilweise im Antriebsgehäuse angeordnet ist und Komponente der Elektronik an anderen Bereichen des Elektrofahrrads 16 angeordnet sind. Zudem ist auch eine Anordnung der Elektronik außerhalb des Antriebsgehäuses denkbar.

Das Elektrofahrrad 16 umfasst zudem beispielhaft einen Boardcomputer 30, der an einem Lenker 32 des Elektrofahrrads 16 angeordnet ist. Der Boardcomputer 30 ist teilweise lösbar mit dem Elektrofahrrad 16 ausgebildet. Der Boardcomputer 30 umfasst eine Anzeigeeinheit 34, die zur Anzeige von Informationen ausgebildet ist. Der Boardcomputer 30 umfasst zudem ein Bedienelement (nicht dargestellt), über das der Benutzer beziehungsweise der Fahrer den Boardcomputer 30 und/oder das Elektrofahrrad 16 steuern kann. Das Bedienelement ist beispielhaft als ein berührungsempfindlicher Bildschirm ausgebildet. Es ist aber ebenso denkbar, dass das Bedienelement des Boardcomputers 30 aus Knöpfen oder Tasten ausgebildet ist. Der Boardcomputer 30 ist mit der Steuereinheit des Elektrofahrrads 16 derart verbunden, dass Informationen ausgetauscht werden können. Beispielsweise ist über die Anzeigeeinheit 34 eine von der Steuereinheit ermittelte Geschwindigkeit, ein eingestellter Unterstützungsgrad des Elektromotors, eine Routeninformation einer Navigationseinheit und ein Ladezustand des Energiespeichers 24 anzeigbar.

Das Elektrofahrrad 16 weist eine drahtlose Kommunikationsschnittstelle auf. Die drahtlose Kommunikationsschnittstelle ist beispielhaft als ein kurzreichweitige Kommunikationsschnittstelle, insbesondere als eine BLE Schnittstelle, ausgebildet. Die drahtlose Kommunikationsschnittstelle ist beispielhaft im Boardcomputer angeordnet. Alternativ sind auch andere kurzreichweitigen Kommunikationsschnittstellen denkbar. Alternativ oder zusätzlich ist ebenso denkbar, dass das Elektrofahrrad 16 eine langreichweitige Kommunikationsschnittstelle aufweist, die zur Verbindung des Elektrofahrrads 16 mit einem Server, beispielsweise einem Web-Server, ausgebildet ist.

Das System umfasst zudem eine externe Vorrichtung 100 in Form eines Smartphones 102. Die externe Vorrichtung 100 weist eine drahtlose Kommunikationsschnittstelle auf, die zur Verbindung der externen Vorrichtung 100 mit dem Elektrofahrrad 16 und mit dem Server 12 ausgebildet ist. Die drahtlose Kommunikationsschnittstelle der externen Vorrichtung 100 umfasst beispielhaft eine BLE Schnittstelle zur Verbindung mit dem Elektrofahrrad 16 und eine LTE-Schnittstelle zur Verbindung mit dem Server 12. Somit kann das Elektrofahrrad 16 mittels der externen Vorrichtung 100 Daten mit dem Server 12 austauschen. Im Falle eines Elektrofahrrads 16 mit einer langreichweitigen Kommunikationsschnittstelle wäre auch ein direkter Austausch von Daten zwischen dem Elektrofahrrad 16 und dem Server 12 möglich.

Zudem weist das Elektrofahrrad 16 eine drahtgebundene Kommunikationsschnittstelle (nicht dargestellt) auf, die zur drahtgebundenen Verbindung des Elektrofahrrads 16 mit einer Diagnosevorrichtung 110, beispielhaft in Form eines Laptops 112, ausgebildet ist. Die drahtgebundene Kommunikationsschnittstelle ist beispielhaft als eine USB-c Schnittstelle ausgebildet, wobei die Diagnosevorrichtung 110 und das Elektrofahrrad 16 mit einem USB-c Kabel 114 miteinander zum Austausch von Daten verbindbar ist. Alternativ ist ebenso denkbar, eine andere USB-Schnittstelle oder eine andere Form einer Kabelverbindung zu verwenden. Alternativ ist ebenso denkbar, dass der Datenaustausch mit dem Diagnosevorrichtung 110 über die drahtlose Kommunikationsschnittstelle erfolgt.

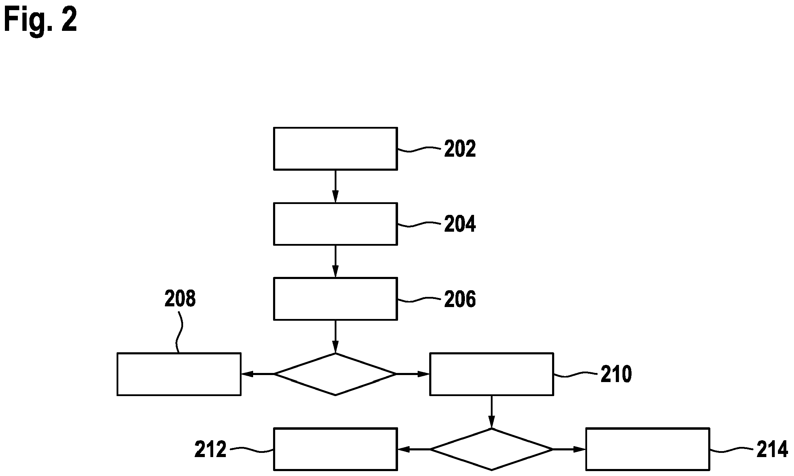

In Fig. 2 ist in einem Flussdiagramm ein beispielhaftes Verfahren zur Diagnose des Elektrofahrrads 16 mittels eines Entscheidungsbaums mittels der Diagnosevorrichtung 110 gezeigt.

In einem ersten Schritt 202 wird das Elektrofahrrad 16 mittels des USB-c Kabels 114 mit der Diagnosevorrichtung 110 verbunden.

In einem zweiten Schritt 204 wird eine Fehlerinformation des Elektrofahrrads 16 der Diagnosevorrichtung 110 bereitgestellt. Die Fehlerinformation wurde beispielhaft durch das Elektrofahrrad 16, insbesondere dem Boardcomputer 30 des Elektrofahrrads 16 erfasst. Die Fehlerinformation ist beispielhaft auf eine Fehlfunktion des Energiespeichers 24 gerichtet.

In einem weiteren Schritt 206 wird basierend auf der Fehlerinformation ein erster Diagnoseverfahrensschritt für das Elektrofahrrad 16 ermittelt, wobei basierend auf dem ersten Diagnoseverfahrensschritt das Elektrofahrrad 16 angesteuert wird. Die Ansteuerung ist beispielhaft derart ausgebildet, dass eine Benutzereingabeaufforderung über den Boardcomputer 30 des Elektrofahrrads 16 angezeigt wird. Der Benutzer überprüft das aufgeforderte Symptom und gibt das Ergebnis über den Boardcomputer 30 ein. Die Eingabe entspricht dabei einem Diagnosesignal, das wiederum der Diagnosevorrichtung 110 bereitgestellt wird.

Liegt das Symptom vor, wird in einem Schritt 208 ein Fehler ermittelt und dem Benutzer über die Diagnosevorrichtung 110 oder über das Elektrofahrrad 16 angezeigt.

Liegt das Symptom nicht vor, so erfolgt basierend auf dem Diagnosesignal in einem Schritt 210 die Ermittlung eines weiteren Diagnoseverfahrensschritts. Zur Ermittlung der Diagnoseverfahrensschritte ist dabei vorzugsweise jeder Diagnoseverfahrensschritt mit einer Kostenkenngröße und einer Nutzenkenngröße versehen. Basierend auf der Fehlerinformation und/oder auf dem Diagnosesignal wird vorteilhaft der weitere Diagnoseverfahrensschritt ermittelt, der am wahrscheinlichsten beziehungsweise am effizientesten zur Ermittlung des Fehlers führt. Beispielhaft erfolgt durch den weiteren ermittelten Diagnoseverfahrensschritt eine weitere Ansteuerung des Elektrofahrrads 16 in Form einer Ansteuerung der Sensoreinheit.

Das von der Sensoreinheit erfasste weitere Diagnosesignal wird wiederum der der Diagnosevorrichtung 110 bereitgestellt. Falls das Ergebnis negativ ist, wird in einem Schritt 212 dem Benutzer angezeigt, dass ein Fehler der Komponente vorliegt und der Energiespeicher 24 auszutauschen ist.

Falls das Ergebnis positiv ist, wird dem Benutzer in einem Schritt 214 angezeigt, dass ein Fehler eines Verbindungskabels vorliegt und dieses ausgetauscht werden muss.

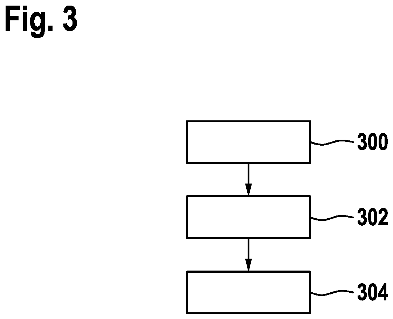

In Fig. 3 ist in einem Flussdiagramm ein beispielhaftes Verfahren zu Generierung eines Entscheidungsbaums, insbesondere zur Zuordnung von Kostenkenngrößen und Nutzenkenngrößen, gezeigt.

In einem ersten Schritt 300 wird für eine Fehlerinformation oder für eine Symptominformation ein Entscheidungsbaum basierend auf Expertenwissen erstellt. Der Entscheidungsbaum kann dabei eine Vielzahl an Diagnoseverfahrensschritte umfassen, die beliebig oder nach Einschätzung des Experten in ihrer Reihenfolge sortiert werden.

In einem zweiten Schritt 302 werden historische Felddaten von dem Server 12 bereitgestellt. Die verwendeten Felddaten wurden dabei von einer Vielzahl an Elektrofahrrädern ermittelt und dem Server 12 über externe Vorrichtungen bereitgestellt. Alternativ ist auch denkbar, dass die Daten dem Server 12 mittels der Diagnosevorrichtungen bereitgestellt werden. Die historischen Felddaten umfassen dabei insbesondere Informationen darüber, mittels welcher Diagnoseverfahrensschritte und mittels welcher Reihenfolge der Diagnoseverfahrensschritte Fehler basierend auf Fehlerinformationen und Symptominformationen ermittelbar gewesen sind. Die Erhebung der Felddaten kann dabei mittels traditioneller Methoden wie einer Statistik über die Fehler und die Ursachen erfolgen. Die Quelle der Felddaten können beispielsweise Log-Daten, Statistiken von gespeicherten Fehlern und Warnungen, persönliches Feedback aus Beobachtungen oder Bewertungen und Informationen aus Serviceberichten sein.

In einem dritten Schritt 304 erfolgt mittels einer Feedbackschleife eine Rückkopplung der Nutzung des Fehlerbaums, sodass dieser kontinuierlich weiterentwickelt wird. Dabei wird durch die Rückkopplung kontinuierlich die Kostenkenngröße und/oder die Nutzenkenngröße der einzelnen Diagnoseverfahrensschritte angepasst und optimiert. Beispielhaft ist das Feedback hierbei als eine binäre Antwort ausgebildet, wobei die Antwort auf die Frage gerichtet ist, ob nach dem Durchlauf des vorgeschlagenen beziehungsweise verwendeten Entscheidungsbaums die korrekte Ursache beziehungsweise der Fehler ermittelt wurde oder nicht. Insbesondere wird durch die Anpassung der Kostenkenngröße und der Nutzenkenngröße die Wahrscheinlichkeit, dass ein Diagnoseverfahrensschritt an einem Durchlauf im Entscheidungsbaum als sinnvolle Option angeboten wird, erhöht, wenn diese bei der Fehlersuche zuvor geholfen hat und verringert, wenn der Diagnoseverfahrensschritt nicht zur Lösung beigetragen hat.

Der Entscheidungsbaum wird dabei derart angepasst, dass basierend auf der Fehlerinformation oder der Symptominformation der richtige Fehler mit einem minimalen Aufwand ermittelt wird.

Der Aufwand ist hierbei beispielhaft als eine gewichtete Summe der Aufwände der einzelnen Diagnoseverfahrensschritte definiert. Der Aufwand eines Diagnoseverfahrensschritts wiederum ist als die Summe seiner Kosten definiert. Diese Kosten bestehen aus i Elementen. Diese sind beispielhaft: Zeit, monetären Kosten, Komplexität und eventuell weiteren Faktoren. Die Kosten werden normiert auf einen Wertebereich [0,1], wobei 0 keinen Kosten entspricht und 1 maximalen Kosten. Diese Kosten $c_i$ können nun noch gegeneinander gewichtet werden mittels einer Gewichtung $w_i$:

$$\text{Kostenkenngröße (Diagnoseverfahrensschritt } m) = \sum_{i=1}^{n} w_i * c_i$$

Der Nutzen eines Diagnoseverfahrensschritts m ist definiert als der Fortschritt zur exakten Diagnose nach Anwenden des Diagnoseverfahrensschritts ausgehend vom Zustand vor dem Diagnoseverfahrensschritts. Auch dieser Wert ist beispielhaft normiert zwischen [0; 1], wobei 0 „keine Verbesserung" bedeutet und 1 „Ursache ist nun exakt bestimmt" bedeutet.

Nutzenkenngröße $N \in [0,1]$

Auch dieser Wert N wird nun gewichtet ($w_N$), so dass es möglich ist, Kosten und Nutzen gegeneinander zu gewichten.

$$Kosten{-}Nutzen{-}Verh\ddot{a}ltnis\ (Diagnosema\beta nahme\ m){=}w_N * N - \sum_{i=1}^{n} w_i * c_i$$

Der Aufwand eines einzelnen Diagnoseverfahrensschritts ist definiert als die Summer der Kosten, die für die Durchführung dieses Diagnoseverfahrensschritts notwendig sind. Als Kosten werden zunächst die benötigte Zeit für die Durchführung des Diagnoseverfahrensschritts gesehen, aber auch die Komplexität und die Notwendigkeit von weiteren Werkzeugen. Dies entspricht dem optimalen Pfad zur korrekten Diagnose.

Idealerweise wird also eine Reihenfolge von Diagnoseverfahrensschritten vorgeschlagen, bei der die Diagnoseverfahrensschritte mit den niedrigsten Kosten (einfach und schnell durchzuführen) die größten Aufschlüsse über die Fehlerursache geben. Mit Hilfe des hier beschriebenen Verfahrens soll der Benutzer also in der Lage sein, möglichst schnell und einfach mit einer möglichst hohen Genauigkeit, den vorliegenden Fehler beziehungsweise die Fehlerursache zu identifizieren.

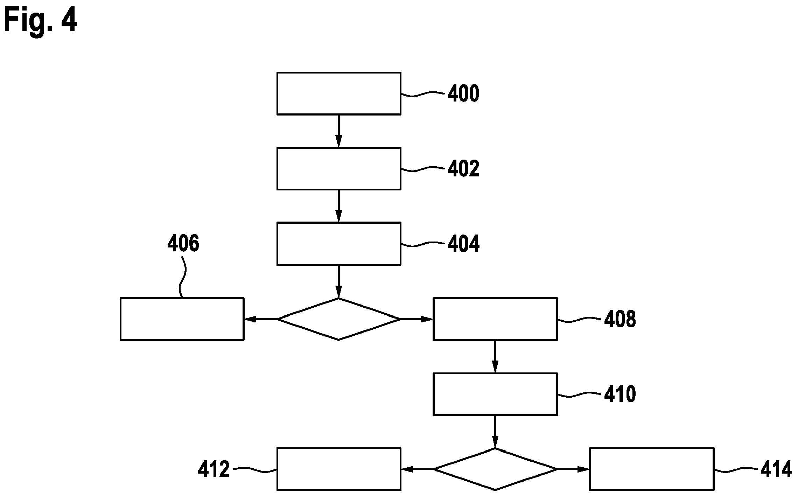

In Fig. 4 ist in einem Flussdiagramm ein weiteres beispielhaftes Verfahren zur Diagnose des Elektrofahrrads 16 mittels eines Entscheidungsbaums gezeigt. Die Diagnose erfolgt dabei beispielhaft teilweise auf der externen Vorrichtung 100.

In einem ersten Schritt 400 wird der externen Vorrichtung 100 eine Symptominformation bereitgestellt. Die Symptominformation wird dabei beispielhaft über eine Benutzereingabe des Fahrers erfasst. Die Symptominformation ist dabei als eine verringerte Leistung der Antriebseinheit 26 des Elektrofahrrads 16 ausgebildet.

In einem Schritt 402 erfolgt ein Starten eines ersten Diagnoseverfahrensschritts basierend auf der Symptominformation. Hierzu wird eine optische Signalkenngröße durch die externe Vorrichtung 100, insbesondere eine Kamera (nicht dargestellt) der externen Vorrichtung 100, erfasst. Bei der optischen Signalkenngröße handelt es sich hierbei beispielhaft um ein Bild Antriebseinheit. Das Bild wir beispielhaft durch den Benutzer und unter Anleitung der externen Vorrichtung gemacht.

Im Anschluss erfolgt in einem Schritt 404 eine Signalverarbeitung der optischen Signalkenngröße. Die Signalverarbeitung umfasst dabei beispielhaft eine Mustererkennung, wobei ermittelt wird, ob ein sichtbarer Schaden and er Antriebseinheit vorliegt.

Liegt ein sichtbarer Schaden vor, wird in einem Schritt 406 ein Austausch der Komponente vorgeschlagen.

Liegt kein sichtbarer Schaden vor, so wird in einem Schritt 408 ein weiterer Diagnoseverfahrensschritt gestartet. Der Benutzer wird mittels des Boardcomputers 30 des Elektrofahrrads 16 oder der externen Vorrichtung 100 dazu aufgefordert mit dem Elektrofahrrad 16 und aktivierter Antriebseinheit 26 zu fahren. Während der Fahrt erfolgt eine Erfassung einer akustischen Signalkenngröße durch ein Mikrofon (nicht dargestellt) der externen Vorrichtung 100.

In einem weiteren Schritt 410 erfolgt eine weitere Signalverarbeitung, wobei eine Frequenzanalyse der akustischen Signalkenngröße erfolgt. Die Frequenzanalyse erfolgt beispielhaft mittels eines maschinellen Lernsystems, bevorzugt einem Deep Learning Algorithmus.

Kann mittels der Frequenzanalyse kein Fehler ermittelt werden, so wird in einem Schritt 412 beispielhaft der Austausch der Komponente beziehungsweise der Antriebseinheit 26 vorgeschlagen.

Kann mittels der Frequenzanalyse der Fehler ermittelt werden, so wird dieser in einem Schritt 414 dem Benutzer über den Boardcomputer 30 oder die externe Vorrichtung 100 angezeigt. Vorzugsweise kann mittels der Frequenzanalyse eine präzise Bestimmung des Fehlers, beispielsweise ein defekter Elektromotor, ein verschlissenes Getriebe oder eine beschädigte Kurbelwelle ermittelt und angezeigt werden.

**Patentansprüche**

1. Verfahren zur Diagnose eines Fahrrads, insbesondere eines Elektrofahrrads (16), mittels eines Entscheidungsbaums umfassend folgende Schritte:

   - Bereitstellung einer Fehlerinformation oder einer Symptominformation;
   - Ermittlung eines Diagnoseverfahrensschritts für das Fahrrad (14) basierend auf der Fehlerinformation oder der Symptominformation;
   - Ansteuerung des Fahrrads (14) basierend auf dem ermittelten Diagnoseverfahrensschritt;
   - Erfassen eines Diagnosesignals basierend auf dem angesteuerten Fahrrad (14);
   - Ermittlung eines weiteren Diagnoseverfahrensschritts, eines Fehlers oder eines ein Symptom begründenden Fehlers basierend auf dem erfassten Diagnosesignal.

**2.** Verfahren nach Anspruch 1, **dadurch gekennzeichnet, dass** die Fehlerinformation durch das Fahrrad (14) bereitgestellt wird.

**3.** Verfahren nach einem der vorhergehenden Ansprüche, **dadurch gekennzeichnet, dass** die Symptominformation durch eine Nutzereingabe bereitgestellt wird.

**4.** Verfahren nach einem der vorhergehenden Ansprüche, **dadurch gekennzeichnet, dass** die Fehlerinformation oder die Symptominformation durch einen Server (12) bereitgestellt wird.

**5.** Verfahren nach einem der vorhergehenden Ansprüche, **dadurch gekennzeichnet, dass** die Ansteuerung des Fahrrads (14) eine mechanische und/oder elektrische Komponente betrifft.

**6.** Verfahren nach einem der vorhergehenden Ansprüche, **dadurch gekennzeichnet, dass** die Ansteuerung des Fahrrads (14) eine Kommunikationsschnittstelle des Fahrrads (14) betrifft.

**7.** Verfahren nach einem der vorhergehenden Ansprüche, **dadurch gekennzeichnet, dass** die Ansteuerung des Fahrrads (14) und das Erfassen des Diagnosesignals automatisch, insbesondere durch das Fahrrad (14), erfolgt.

**8.** Verfahren nach einem der vorhergehenden Ansprüche, **dadurch gekennzeichnet, dass** das Diagnosesignal mittels einer Benutzereingabe erfasst wird.

**9.** Verfahren nach einem der vorhergehenden Ansprüche, **dadurch gekennzeichnet, dass** das Verfahren vollständig oder teilweise automatisch erfolgt, wobei das teilweise automatische Verfahren lediglich die Symptominformation als Benutzereingabe benötigt.

**10.** Verfahren nach einem der vorhergehenden Ansprüche, **dadurch gekennzeichnet, dass** basierend auf dem weiteren Diagnoseverfahrensschritt eine Benutzereingabeaufforderung erfolgt.

**11.** Verfahren nach einem der vorhergehenden Ansprüche, **dadurch gekennzeichnet, dass** dem Diagnoseverfahrensschritt, insbesondere jedem Diagnoseverfahrensschritt, eine Kostenkenngröße und/oder eine Nutzenkenngröße zugeordnet ist.

**12.** Verfahren nach einem der vorhergehenden Ansprüche, **dadurch gekennzeichnet, dass** eine Reihenfolge der Verfahrensschritte basierend auf historischer Felddaten geändert wird.

**13.** Verfahren nach einem der vorhergehenden Ansprüche, **dadurch gekennzeichnet, dass** der Fehlerbaum, insbesondere eine Reihenfolge der ermittelten Diagnoseverfahrensschritte, mittels einer Rückkoppelungsschleife optimiert wird.

**14.** Verfahren nach einem der vorhergehenden Ansprüche, **dadurch gekennzeichnet, dass** der Fehlerbaum, insbesondere die Reihenfolge der ermittelten Diagnoseverfahrensschritte, mittels eines maschinellen Lernsystems angepasst wird.

**15.** Verfahren nach einem der Ansprüche 13 oder 14, **dadurch gekennzeichnet, dass** die Kostenkenngröße und/oder die Nutzenkenngröße basierend auf der Rückkopplungsschleife oder des maschinellen Lernsystems angepasst wird.

Fig. 1

Fig. 2

# Fig. 3

**Fig. 4**

Europäisches
Patentamt

European
Patent Office

Office européen
des brevets

# EUROPÄISCHER RECHERCHENBERICHT

**Nummer der Anmeldung**

**EP 23 16 9530**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2020/017155 A1 (HU ZHIFENG [CN] ET AL) 16. Januar 2020 (2020-01-16) * Absätze [0019], [0071], [0125] – [0130] * ----- | 1-15 | INV. G06Q10/20 G07C5/08 G01R31/00 |
| Y | US 2016/321845 A1 (MAEDA TOMOKO [JP] ET AL) 3. November 2016 (2016-11-03) * Absätze [0045] – [0047]; Abbildungen 4-7 * ----- | 1-15 | |
| Y | DE 10 2019 218724 A1 (BOSCH GMBH ROBERT [DE]) 10. Juni 2021 (2021-06-10) * Absätze [0007] – [0018]; Ansprüche 1-4; Abbildungen 1-2 * ----- | 1-15 | |
| Y | US 2020/250246 A1 (MEYER JAMES [US] ET AL) 6. August 2020 (2020-08-06) * Absätze [0005], [0028] – [0037]; Abbildungen 3,7 * ----- | 1-15 | |

**RECHERCHIERTE SACHGEBIETE (IPC)**

G06Q
G07C

Der vorliegende Recherchenbericht wurde für alle Patentansprüche erstellt

| Recherchenort | Abschlußdatum der Recherche | Prüfer |
|---|---|---|
| München | 25. September 2023 | Kerschbaumer, J |

KATEGORIE DER GENANNTEN DOKUMENTE

X : von besonderer Bedeutung allein betrachtet
Y : von besonderer Bedeutung in Verbindung mit einer
  anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
  nach dem Anmeldedatum veröffentlicht worden ist
D : in der Anmeldung angeführtes Dokument
L : aus anderen Gründen angeführtes Dokument
........................................................................
& : Mitglied der gleichen Patentfamilie, übereinstimmendes
  Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 23 16 9530

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

25-09-2023

| Im Recherchenbericht angeführtes Patentdokument | Datum der Veröffentlichung | Mitglied(er) der Patentfamilie | Datum der Veröffentlichung |
|---|---|---|---|
| US 2020017155 A1 | 16-01-2020 | EP 3538424 A1 | 18-09-2019 |
| | | JP 2020504938 A | 13-02-2020 |
| | | US 2020017155 A1 | 16-01-2020 |
| | | US 2022269260 A1 | 25-08-2022 |
| | | WO 2018107978 A1 | 21-06-2018 |
| US 2016321845 A1 | 03-11-2016 | CN 105873798 A | 17-08-2016 |
| | | JP 6418503 B2 | 07-11-2018 |
| | | JP WO2015111395 A1 | 23-03-2017 |
| | | US 2016321845 A1 | 03-11-2016 |
| | | WO 2015111395 A1 | 30-07-2015 |
| DE 102019218724 A1 | 10-06-2021 | CN 114766045 A | 19-07-2022 |
| | | DE 102019218724 A1 | 10-06-2021 |
| | | EP 4070292 A1 | 12-10-2022 |
| | | JP 2023506401 A | 16-02-2023 |
| | | US 2022398877 A1 | 15-12-2022 |
| | | WO 2021110632 A1 | 10-06-2021 |
| US 2020250246 A1 | 06-08-2020 | CN 111524250 A | 11-08-2020 |
| | | DE 102020000758 A1 | 06-08-2020 |
| | | EP 3694184 A1 | 12-08-2020 |
| | | TW 202040968 A | 01-11-2020 |
| | | US 2020250246 A1 | 06-08-2020 |

EPO FORM P0461

Für nähere Einzelheiten zu diesem Anhang : siehe Amtsblatt des Europäischen Patentamts, Nr.12/82